# EUROPEAN PATENT APPLICATION

(11) **EP 2 728 637 A1**
(43) Date of publication of application: **07.05.2014**
(21) Application number: 11868687.2
(22) Date of filing: 30.06.2011
(51) Int. Cl.: H01L 51/50, H01L 51/52, H01L 51/54, H01L 51/56

(54) **TOP-EMITTING ORGANIC ELECTROLUMINESCENT DEVICE AND MANUFACTURING METHOD THEREOF**

(71) Applicant: Ocean's King Lighting Science&Technology Co., Ltd., Shenzhen, Guangdong 518054 (CN)
(72) Inventor: ZHOU, Mingjie, Shenzhen Guangdong 518054 (CN); WANG, Ping, Shenzhen Guangdong 518054 (CN); ZHONG, Tietao, Shenzhen Guangdong 518054 (CN)
(74) Representative: Lenthall, Joseph
(86) International application number: PCT/CN2011/076714
(87) International publication number: WO 2013/000164

(57) **Abstract**

A top-emitting organic electroluminescent device and a manufacturing method thereof are provided. The device comprises a substrate (101), an anode layer (102), a hole-injecting layer (103), a hole-transporting layer (104), a light-emitting layer (105), an electron-transporting layer (106), an electron-injecting layer (107), and a cathode layer (108), which are stacked in order. The cathode layer (108) comprises an aluminum layer (1081) and a composite thin film (1082), which consists of Ag and SiO. The aluminum layer (1081) is deposited on the electron-injecting layer (107), and the composite thin film (1082) is deposited on the aluminum layer (1081). The cathode layer (108) has a composite-layer structure consisting of the Ag and the SiO, so the light transmittance of the device is enhanced, and the emission efficiency of the device can be improved.

## Description

### FIELD OF THE INVENTION

The present invention relates to the field of optoelectronic devices, and particularly relates to a top-emitting organic electroluminescent device. The present invention also relates to a method for preparing the top-emitting organic electroluminescent device.

### BACKGROUND OF THE INVENTION

Organic electroluminescent device (also known as Organic Light Emission Diode, hereinafter referred to as OLED), has characteristics such as high luminance, wide selection of material, low driving voltage and solid-state self-luminosity, as well as advantages such as high definition, wide viewing angle, smooth motion display and fast response. OLED can be made into flexible structure, and can be folded and bent, such OLED is a kind of potential flat-panel display and flat light source, it not only conforms to the development trends of mobile communication and information display in the information age, but also meets the requirements of green lighting technology. It has become a hot research field in recent years.

Organic electroluminescent device has a structure similar to sandwich, comprising cathode and anode positioned separately on the top and the bottom, and monolayer or multilayer functional layer(s) of organic materials sandwiched between the electrodes. The functional layers of organic materials have different materials and different structures. The functional layers are, in order, hole-injecting layer, hole-transporting layer, light-emitting layer, electron-transporting layer, electron-injecting layer. Organic electroluminescent device is carrier injecting-type light emitting device. Once supplying working voltage to anode and cathode, hole from the anode and electrons from the cathode will inject into organic material layer of the device, and form hole-electron pairs, then light emits from one side of the electrodes.

However, most of the structures of current OLED are the type of bottom emission, the light transmittance of OLED is relatively low. Metal Ag is generally used as cathode material, better transmittance can be obtained when thin Ag is employed. Nevertheless, work function of Ag is 4.6 eV, there is relatively high barrier between it and LUMO energy level of normal electron transport materials. In addition, thick Ag will lead to relatively low light transmittance of Ag layer.

### SUMMARY OF THE INVENTION

The purpose of the present invention is to provide a top-emitting organic electroluminescent device having a high visible transmittance.

A top-emitting organic electroluminescent device comprising a substrate, an anode layer, a hole-injecting layer, a hole-transporting layer, a light-emitting layer, an electron-transporting layer, an electron-injecting layer and a cathode layer stacked in order; wherein said cathode layer comprises:
an aluminum layer, which is deposited on the surface of said electron-injecting layer, and
a composite thin film of silver and SiO, which is deposited on the surface of said aluminum layer.

In said composite thin film of said top-emitting organic electroluminescent device, mass percentage of silver is in the range of 45-90%, and thickness of aluminum layer is in the range of 0.3-1 nm, thickness of said composite thin film is in the range of 20-35 nm.

In the top-emitting organic electroluminescent device of the present invention, material of the substrate is polymer thin film, such as polyethylene terephthalate (PET), polyether sulfone (PES), transparent polyimide (PI) or polycarbonate (PC).

Material of hole-injecting layer, hole-transporting layer, light-emitting layer, electron-transporting layer and electron-injecting layer of the top-emitting organic electroluminescent device is commonly used in the art, such as:

Material of hole-injecting layer is selected from the group consisting of 4,4',4'-tris(N-3-methylphenyl-N-phenyl-amino)- triphenylamine (m-MTDATA) and copper phthalocyanine (CuPc);

Material of hole-transporting layer is selected from the group consisting of NPB (N,N'-di-[(1-naphthalenyl)-N,N'-diphenyl]- (4.4'-biphenyl)- 4,4'- diamine), TPD (N,N'-bis(3-methylphenyl)-N,N'-diphenyl-benzidine) and TCTA (4,4',4"-tris(carbazol-9-yl)-triphenylamine);

Material of light-emitting is selected from Alq₃:C545T (wherein, C545T (1H,5H,11H-[1]benzopyrano[6,7,8-ij]quinolizin-11-one) is guest material, Alq₃ (tris(8-hydroxyquinolinato)aluminum) is host material, doping mass percentage of the guest material is 2%), FIrpic:CBP (wherein, FIrpic (bis(4,6-difluorophenylpyridinato-N,C2)picolinatoiridium) is guest material, CBP (4,4'-bis(N-carbazolyl)-1,1'-biphenyl) is host material, doping mass percentage of the guest material is 8%), TPBi:Ir(ppy)₃ (wherein, Ir(ppy)₃ (tris(₂-phenylpyridine)iridium) is guest material, TPBi (1,3,5-tris(1-phenyl-1H-benzimidazol-2-yl)benzene) is host material, doping mass percentage of the guest material is 4%), DPVBi (4,4'-bis(2,2-diphenyl vinyl)-1,1'-biphenyl) and composite layer consisting of DPVBi and Rubrene (i.e. DPVBi/Rubrene).

Material of electron-transporting is selected from the group consisting of tris(8-hydroxyquinolinato)aluminum (Alq₃), 4,7-diphenyl-1,10-phenanthroline (Bphen) and 1,3,5-tris(1-phenyl-1H-benzimidazol-2-yl)benzene (TPBi);

Material of electron-injecting layer is selected from the group consisting of LiF, CsF and Li₂O.

Material of said anode layer is selected from Ag, Al, Au and other metals.

The present invention also provides a method for preparing the top-emitting organic electroluminescent device, which comprises the following steps:
S1, washing and drying substrate;
S2, vapor depositing an anode layer on the surface of said substrate by vacuum coating method;
S3, vapor depositing hole-injecting layer, hole-transporting layer, light-emitting layer, electron-transporting layer and electron-injecting layer stacked in order on the surface of said anode layer in sequence by vacuum coating method;
S4, vapor depositing an aluminum layer on the surface of electron-injecting layer, then vapor depositing composite thin film of silver and SiO on the surface of said aluminum layer, said aluminum layer and the composite thin film of silver and SiO form a cathode layer having multilayer composite structure;
obtaining said top-emitting organic electroluminescent device after completion of the above process.

In the top-emitting organic electroluminescent device provided in the present invention, cathode layer has composite-layer structure consisting of aluminum layer and composite thin film of silver and SiO, visible transmittance of cathode reaches 70-80%, thus improving light extraction efficiency at the surface of cathode layer; accordingly, luminous efficiency of the device is improved from 9.2 lm/W to the range of 19.2-22.3 lm/W.

### BRIEF DESCRIPTION OF THE DRAWINGS

Fig. 1 is a structural view of the top-emitting organic electroluminescent device of the present invention; wherein,
101 substrate, 102 anode layer, 103 hole-injecting layer, 104 hole-transporting layer, 105 light-emitting layer, 106 electron-transporting layer, 107 electron-injecting layer, 108 cathode layer;
Fig. 2 is a flow diagram showing the preparation of top-emitting organic electroluminescent device of the present invention;
Fig. 3 shows current density-voltage curves of the organic electroluminescent devices manufactured in Example 1, Comparative Example 1 and Comparative 1.

### DETAILED DESCRIPTION OF ILLUSTRATED EMBODIMENTS

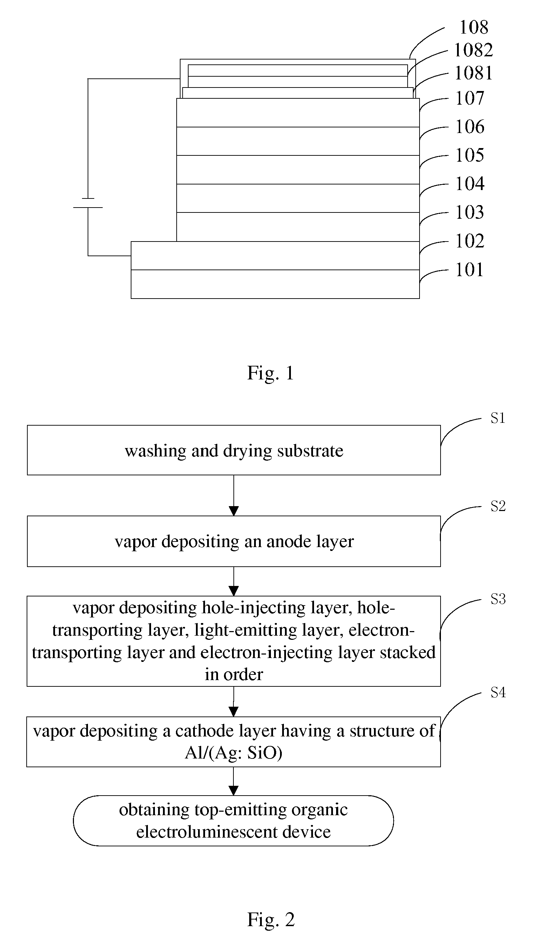

The top-emitting organic electroluminescent device provided in the present invention, as shown in Fig. 1, comprises a substrate 101, an anode layer 102, a hole-injecting layer 103, a hole-transporting layer 104, a light-emitting layer 105, an electron-transporting layer 106, an electron-injecting layer 107 and a cathode layer 108 stacked in order, wherein said cathode layer 108 comprises an aluminum layer 1081, which is deposited on the surface of said electron-injecting layer 107, and a composite thin film 1082 of silver and SiO, which is deposited on the surface of said aluminum layer 1081; i.e. substrate 101/anode layer 102/hole-injecting layer 103/hole-transporting layer 104/light-emitting layer 105/electron-transporting layer 106/electron-injecting layer 107/aluminum (Al) layer 1081/composite thin film 1082 of silver and SiO; Ag: SiO represents composite thin film of silver and SiO, so the structure of said cathode layer 108 is Al layer 1081/(Ag: SiO) layer 1082.

In said composite thin film of said top-emitting organic electroluminescent device, mass percentage of silver is in the range of 45-90%, and thickness of aluminum layer is in the range of 0.3-1 nm, thickness of said composite thin film is in the range of 20-35 nm. In the composite thin film 1082 of Ag and SiO, SiO can enhance the transmittance of said cathode layer, visible transmittance of said Ag: SiO composite thin film reaches 70-80%; in addition, during vapor depositing process, SiO react with metal Ag to partially produce metallic oxide AgO, and also improve electron injecting ability of electrodes.

In the top-emitting organic electroluminescent device, material of the substrate 101 is polymer thin film, such as polyethylene terephthalate (PET), polyether sulfone (PES), transparent polyimide (PI), transparent polyimide (PI) or polycarbonate (PC). Given that the top-emitting organic electroluminescent device is a top-emitting OLED device, so the substrate material which is polymer film must be subjected to flat and hardening treatment to achieve a surface hardness of up to 2H-3H (pencil hardness).

Material of hole-injecting layer, hole-transporting layer, light-emitting layer, electron-transporting layer and electron-injecting layer of the top-emitting organic electroluminescent device is commonly used in the art, such as:

Material of hole-injecting layer is selected from the group consisting of 4,4',4'-tris(N-3-methylphenyl-N-phenyl-amino)- triphenylamine (m-MTDATA) and copper phthalocyanine (CuPc);

Material of hole-transporting layer is selected from the group consisting of NPB (N,N'-di-[(1-naphthalenyl)-N,N'-diphenyl]- (4.4'-biphenyl)- 4,4'- diamine), TPD (N,N'-bis(3-methylphenyl)-N,N'-diphenyl-benzidine) and TCTA (4,4',4"-tris(carbazol-9-yl)-triphenylamine);

Material of light-emitting is selected from Alq₃:C545T (wherein, C545T (1H,5H,11H-[1]benzopyrano[6,7,8-ij]quinolizin-11-one) is guest material, Alq₃ (tris(8-hydroxyquinolinato)aluminum) is host material, doping mass percentage of the guest material is 2%), FIrpic: CBP (wherein, FIrpic (bis(4,6-difluorophenylpyridinato-N,C2)picolinatoiridium) is guest material, CBP (4,4'-bis (N-carbazolyl)-1,1'-biphenyl) is host material, doping mass percentage of the guest material is 8%), TPBi: Ir(ppy)₃ (wherein, Ir(ppy)₃ (tris(2-phenylpyridine)iridium) is guest material, TPBi (1,3,5-tris(1-phenyl-1H-benzimidazol-2-yl)benzene) is host material, doping mass percentage of the guest material is 4%), DPVBi (4,4'-bis(2,2-diphenyl vinyl)-1,1'-biphenyl) and composite layer consisting of DPVBi and Rubrene (i.e. DPVBi/Rubrene).

Material of electron-transporting is selected from the group consisting of tris(8-hydroxyquinolinato)aluminum (Alq₃), 4,7-diphenyl-1,10-phenanthroline (Bphen) and 1,3,5-tris(1-phenyl-1H-benzimidazol-2-yl)benzene (TPBi);

Material of electron-injecting layer is selected from the group consisting of LiF, CsF and Li₂O.

Material of said anode layer is selected from metal Ag, Al and Au. Thickness of said anode layer is in the range of 60-150 nm.

The present invention also provides a method for preparing top-emitting organic electroluminescent device as shown in Fig. 2, which comprises the following steps:
S1. placing substrate (e.g. polymer film) into deionized water containing detergent for ultrasonic cleaning, washing with deionized water, ultrasonically treating successively with isopropanol and acetone, then blow drying with nitrogen for later use; wherein, polymer film comprises polyethylene terephthalate (PET), polyether sulfone (PES), polyethylene naphthalate (PEN) and polycarbonate (PC);
S2, vapor depositing an anode layer on the surface of the cleaned substrate by vacuum coating method, thickness of the anode layer is in the range of 60-150 nm;
S3, vapor depositing hole-injecting layer, hole-transporting layer, light-emitting layer, electron-transporting layer and electron-injecting layer stacked in order on the surface of anode layer by vacuum coating method; thicknesses of said hole-injecting layer, hole-transporting layer, light-emitting layer, electron-transporting layer and electron-injecting layer are in the range of, in order, 30-40 nm, 20-50 nm, 15-20 nm, 30-40 nm and 1 nm;
S4, vapor depositing an aluminum layer of 0.3-1 nm thick on the surface of electron-injecting layer, then vapor depositing composite thin film of silver and SiO (i.e. Ag:SiO) of 20-35 nm thick on the surface of said aluminum layer, said aluminum layer and the composite thin film of silver and SiO form a cathode layer having multilayer composite structure;
obtaining said top-emitting organic electroluminescent device after completion of the above process.

Step S1 further comprises cleaning process of polymer thin film. Firstly, polymer thin film substrate was placed into deionized water containing detergent for ultrasonic cleaning, ultrasonically treated successively with isopropanol and acetone for 20 min, then blow dried with nitrogen.

### Step S2 further comprises surface treatment of said anode layer:

After the preparation of anode, anode layer must be placed into plasma processor for plasma treatment; so that the plasma treated anode layer can reduce the hole injecting barrier.

### Step S4 further comprises steps of preparing Ag: SiO:

Placing Ag and SiO into two evaporators separately, evaporating two material simultaneously by thermal deposition method, forming mixture film, controlling the proportion of the material in the film by adjusting evaporation velocity to obtain Ag: SiO layer.

In the top-emitting organic electroluminescent device provided in the present invention, cathode layer has composite-layer structure consisting of aluminum layer and composite thin film of silver and SiO, visible transmittance of cathode reaches 70-80%, thus improving light extraction efficiency at the surface of cathode layer; accordingly, luminous efficiency of the device is improved from 9.2 lm/W to the range of 19.2-22.3 lm/W.

Further description of the present invention will be illustrated, which combined with preferred embodiments and the drawings.

### Example 1

The top-emitting organic electroluminescent device of the Example 1 has a structure of PET/Ag/m-MTDATA/ NPB/ C545T:Alq₃/ Alq₃/LiF/ Ag/(Ag:SiO).

The method for preparing the top-emitting organic electroluminescent device is as follows.

PET film substrate was placed into deionized water containing detergent for ultrasonic cleaning, ultrasonically treated successively with isopropanol and acetone for 20 min, then blow dried with nitrogen.

In vacuum coating system, Ag of 60 nm thick was deposited on the surface of PET film to serve as anode. The anode was treated with oxygen plasma for 2 min.

After the processing, the following layers were deposited in sequence on anode: hole-injecting layer of m-MTDATA having a thickness of 30 nm, hole-transporting layer of NPB having a thickness of 50 nm, light-emitting layer of C545T:Alq₃ (wherein, C545T is guest material, Alq₃ is host material; doping mass percentage of the guest material was 2%) having a thickness of 20 nm, electron-transporting layer of Alq₃ having a thickness of 40 nm, electron-injecting layer of LiF having a thickness of 1 nm.

Then cathode layer having a structure of Al/(Ag: SiO) was vapor deposited, wherein thickness of Al was 0.3 nm, Ag: SiO was 20 nm, and mass percentage of Ag in Ag: SiO was 45.2%.

### Example 2

The top-emitting organic electroluminescent device of the Example 2 has a structure of PC /Al/m-MTDATA/ TPD/ DPVBi/ Bphen/CsF/ Al/(Ag: SiO).

The method for preparing the top-emitting organic electroluminescent device is as follows.

PC film substrate was placed into deionized water containing detergent for ultrasonic cleaning, ultrasonically treated successively with isopropanol and acetone for 20 min, then blow dried with nitrogen.

In vacuum coating system, Al of 80 nm thick was deposited on the surface of PC film to serve as anode. The anode was treated with oxygen plasma for 5 min.

After the processing, the following layers were deposited in sequence on anode: hole-injecting layer of m-MTDATA having a thickness of 30 nm, hole-transporting layer of TPD having a thickness of 40 nm, light-emitting layer of DPVBi having a thickness of 20 nm, electron-transporting layer of Bphen having a thickness of 40 nm, electron-injecting layer of CsF having a thickness of 1 nm.

Then cathode layer having a structure of Al/(Ag: SiO) was vapor deposited, wherein thickness of Al was 1 nm, Ag: SiO was 25 nm, and mass percentage of Ag in Ag: SiO was 65.8%.

### Example 3

The top-emitting organic electroluminescent device of the Example 3 has a structure of PI/Ag/CuPc/TCTA/ TPBi:Ir(ppy)₃/TPBi/Li2O/ Al/(Ag: SiO).

The method for preparing the top-emitting organic electroluminescent device is as follows.

PI film substrate was placed into deionized water containing detergent for ultrasonic cleaning, ultrasonically treated successively with isopropanol and acetone for 20 min, then blow dried with nitrogen.

In vacuum coating system, Ag of 100 nm thick was deposited on the surface of PI film to serve as anode. The anode was treated with oxygen plasma for 2 min.

After the processing, the following layers were deposited in sequence on anode: hole-injecting layer of CuPc having a thickness of 30 nm, hole-transporting layer of TCTA having a thickness of 50 nm, light-emitting layer of TPBi:Ir(ppy)₃ (wherein, TPBi is host material, Ir(ppy)₃ is guest material; doping mass percentage of the guest material was 4%) having a thickness of 20 nm, electron-transporting layer of TPBi having a thickness of 20 nm, electron-injecting layer of Li₂O having a thickness of 1 nm.

Then cathode layer having a structure of Al/(Ag: SiO) was vapor deposited, wherein thickness of Al was 0.3 nm, Ag: SiO was 35 nm, and mass percentage of Ag in Ag: SiO was 75.8%.

### Example 4

The top-emitting organic electroluminescent device of the Example 4 has a structure of PEN /Au/ m-MTDATA/ NPB/ FIrpic: CBP / Alq₃/LiF/ Al/(Ag: SiO).

The method for preparing the top-emitting organic electroluminescent device is as follows.

PEN film substrate was placed into deionized water containing detergent for ultrasonic cleaning, ultrasonically treated successively with isopropanol and acetone for 20 min, then blow dried with nitrogen.

In vacuum coating system, Au of 120 nm thick was deposited on the surface of PEN film to serve as anode. The anode was treated with oxygen plasma for 2 min.

After the processing, the following layers were deposited in sequence on anode: hole-injecting layer of m-MTDATA having a thickness of 30 nm, hole-transporting layer of NPB having a thickness of 50 nm, light-emitting layer of FIrpic: CBP (wherein, FIrpic is guest material, CBP is host material; doping mass percentage of the guest material was 8%) having a thickness of 20 nm, electron-transporting layer of Alq₃ having a thickness of 20 nm, electron-injecting layer of LiF having a thickness of 1 nm.

Then cathode layer having a structure of Al/(Ag: SiO) was vapor deposited, wherein thickness of Al was 0.5 nm, Ag: SiO was 20 nm, and mass percentage of Ag in Ag: SiO was 89.7%.

### Comparative Example 1

The organic electroluminescent device of the Comparative Example 1 has a structure of PET/Ag/m-MTDATA/NPB/ C545T:Alq₃/ Alq₃/LiF/Ag.

The method for preparing the organic electroluminescent device is as follows.

PET film substrate was placed into deionized water containing detergent for ultrasonic cleaning, ultrasonically treated successively with isopropanol and acetone for 20 min, then blow dried with nitrogen.

In vacuum coating system, Ag of 60 nm thick was deposited on the surface of PET film to serve as anode. The anode was treated with oxygen plasma for 2 min.

After the processing, the following layers were deposited in sequence on anode: hole-injecting layer of m-MTDATA having a thickness of 30 nm, hole-transporting layer of NPB having a thickness of 50 nm, light-emitting layer of C545T:Alq₃ (wherein, C545T (1H,5H,11H-[1]benzopyrano[6,7,8-ij]quinolizin-11-one) is guest material, Alq₃ (tris(8-hydroxyquinolinato)aluminum) is host material; doping mass percentage of the guest material was 2%) having a thickness of 20 nm, electron-transporting layer of Alq3 having a thickness of 40 nm, electron-injecting layer of LiF having a thickness of 1 nm, and cathode layer of Ag having a thickness of 20 nm.

### Comparative Example 2

The organic electroluminescent device of the Comparative Example 2 has a structure of PET/Ag/m-MTDATA/NPB/ C545T:Alq₃/ Alq₃/LiF/ Ag /ITO.

The method for preparing the organic electroluminescent device is as follows.

PET film substrate was placed into deionized water containing detergent for ultrasonic cleaning, ultrasonically treated successively with isopropanol and acetone for 20 min, then blow dried with nitrogen.

In vacuum coating system, Ag of 60 nm thick was deposited on the surface of PET film to serve as anode. The anode was treated with oxygen plasma for 2 min.

After the processing, the following layers were deposited in sequence on anode: hole-injecting layer of m-MTDATA having a thickness of 30 nm, hole-transporting layer of NPB having a thickness of 50 nm, light-emitting layer of C545T:Alq₃ (wherein, C545T is guest material, Alq₃ is host material; doping mass percentage of the guest material was 2%) having a thickness of 20 nm, electron-transporting layer of Alq₃ having a thickness of 40 nm, electron-injecting layer of LiF having a thickness of 1 nm, and ITO cathode having a thickness of 50 nm, which was prepared by low frequency sputtering.

Luminous properties of the devices prepared in Examples 1, 2, 3, 4 and Comparative Example 1 comprising luminance at 8V (driving voltage) and max luminous efficiency were tested, results were shown in Table. 1.

**Table. 1**

| | Example 1 | Example 2 | Example 3 | Example 4 | Comparative Example 1 | Comparative Example2 |
|---|---|---|---|---|---|---|
| transmittance | 79.8% | 78.5% | 70.2% | 74.5% | 62.5% | 82.3% |
| Luminance at 8V (cd/m²) | 4563 | 4146 | 3965 | 4233 | 3015 | 1026 |
| Luminous efficiency (lm/W) | 21.4 | 22.3. | 19.2 | 20.2 | 12.6 | 9.3 |

It can be seen from Table. 1 that Al/(Ag: SiO) composite structure not only enhance transmittance of cathode layer, but also ensure better conductivity; Furthermore, electron-injecting property is better than thin metal Ag and ITO electrode of Comparative Example 1, so the data of the luminescence properties are good.

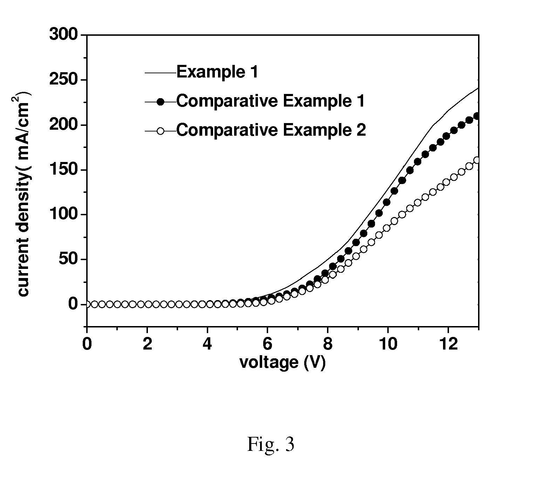

Fig. 3 shows current density-voltage curves of the organic electroluminescent devices manufactured in Example 1, Comparative Example 1 and Comparative 2.

From Fig. 3 it can be seen that the cathode layer having Al/(Ag: SiO) composite structure provided in Example 1 of the present invention has better electron injection, leading to higher current density at the same driving voltage.

While the present invention has been described with reference to particular embodiments, it will be understood that the embodiments are illustrative and that the invention scope is not so limited. Alternative embodiments of the present invention will become apparent to those having ordinary skill in the art to which the present invention pertains. Such alternate embodiments are considered to be encompassed within the spirit and scope of the present invention. Accordingly, the scope of the present invention is described by the appended claims and is supported by the foregoing description.

## Claims

1. A top-emitting organic electroluminescent device comprising a substrate, an anode layer, a hole-injecting layer, a hole-transporting layer, a light-emitting layer, an electron-transporting layer, an electron-injecting layer and a cathode layer stacked in order, wherein said cathode layer comprises:
an aluminum layer, which is deposited on the surface of said electron-injecting layer, and
a composite thin film of silver and SiO, which is deposited on the surface of said aluminum layer.

2. The top-emitting organic electroluminescent device according to claim 1, wherein in said composite thin film, mass percentage of silver is in the range of 45%-90%.

3. The top-emitting organic electroluminescent device according to claim 1 or 2, wherein thickness of said aluminum layer is in the range of 0.3-1 nm, thickness of said composite thin film is in the range of 20-35 nm.

4. The top-emitting organic electroluminescent device according to claim 1, wherein material of said substrate is polyethylene terephthalate, polyether sulfone, transparent polyimide or polycarbonate.

5. The top-emitting organic electroluminescent device according to claim 1, wherein material of said anode layer is silver, aluminum or gold.

6. A method for preparing top-emitting organic electroluminescent device, comprising:
S1, washing and drying substrate;
S2, vapor depositing an anode layer on the surface of said substrate;
S3, vapor depositing hole-injecting layer, hole-transporting layer, light-emitting layer, electron-transporting layer and electron-injecting layer stacked in order on the surface of said anode layer;
S4, vapor depositing an aluminum layer on the surface of electron-injecting layer, then vapor depositing composite thin film of silver and SiO on the surface of said aluminum layer; said aluminum layer and the composite thin film of silver and SiO form a cathode layer having multilayer composite structure;
obtaining said top-emitting organic electroluminescent device after completion of the above process.

7. The method for preparing top-emitting organic electroluminescent device according to claim 6, wherein in said composite thin film, mass percentage of silver is in the range of 45%-90%.

8. The method for preparing top-emitting organic electroluminescent device according to claim 6 or 7, wherein thickness of said aluminum layer is in the range of 0.3-1 nm, thickness of said composite thin film is in the range of 20-35 nm.

9. The method for preparing top-emitting organic electroluminescent device according to claim 6, wherein material of said substrate is polyethylene terephthalate, polyether sulfone, transparent polyimide or polycarbonate.

10. The method for preparing top-emitting organic electroluminescent device according to claim 6, wherein material of said anode layer is silver, aluminum or gold.
